# EUROPÄISCHE PATENTSCHRIFT

(11) **EP 2 840 410 B1**
(45) Veröffentlichungstag und Bekanntmachung des Hinweises auf die Patenterteilung: **22.01.2020**
(21) Anmeldenummer: 14002763.2
(22) Anmeldetag: 07.08.2014
(51) Int. Cl.: G01R 33/3873, G01F 1/716, G01F 15/00, G01N 24/08

(54) **Homogenisierungsvorrichtung zur Homogenisierung eines Magnetfelds**
Homogenisation device for homogenising a magnetic field
Dispositif d'homogénéisation d'un champ magnétique

(30) Priorität: 20.08.2013 DE 102013013719
(43) Veröffentlichungstag der Anmeldung: 25.02.2015
(73) Patentinhaber: Krohne AG, 4019 Basel (CH)
(72) Erfinder: de Graaf, Ariël, 3511 BV Utrecht (NL); Van der Linden, Henry, 3581 GN Utrecht (NL); Pors, Jan Teunis Aart, 3262 EK Oud-Beijerland (NL); Ramondt, Jan-Willem, 481 KL Breda (NL)
(74) Vertreter: Gesthuysen Patent- und Rechtsanwälte

(56) Entgegenhaltungen:
- EP-A1- 1 612 575
- WO-A1-2011/122403
- DE-A1- 1 920 627
- DE-C1- 19 901 332
- GB-A- 2 405 935
- JP-A- H01 280 447
- US-A- 4 901 018
- US-A- 5 923 235
- US-A- 5 999 076
- WINDT C W ET AL: "A portable Halbach magnet that can be opened and closed without force: The NMR-CUFF", JOURNAL OF MAGNETIC RESONANCE, ACADEMIC PRESS, ORLANDO, FL, US, Bd. 208, Nr. 1, 1. Januar 2011 (2011-01-01), Seiten 27-33, XP027590379, ISSN: 1090-7807 [gefunden am 2010-10-30]

## Beschreibung

Die Erfindung betrifft eine Homogenisierungsvorrichtung zur Homogenisierung eines Magnetfelds mit einem amagnetischen Träger und zumindest teilweise aus einem magnetischen Material bestehenden Abgleichelementen, wobei der Träger eine Trägerwandung aufweist und die Trägerwandung einen Trägerinnenraum umgibt, wobei bei im Magnetfeld angeordneter Homogenisierungsvorrichtung das Magnetfeld durch einen ersten Trägerbereich der Trägerwandung in den Trägerinnenraum eindringt und durch einen zweiten Trägerbereich der Trägerwandung aus dem Trägerinnenraum ausdringt und wobei jedes der am Träger angeordneten Abgleichelemente zur Homogenisierung des Magnetfelds zumindest im Trägerinnenraum beiträgt.

Homogenisierungsvorrichtungen der eingangs bestimmten Art können in verschiedenen Anwendungen zur Homogenisierung eines Magnetfelds eingesetzt werden. Nur eine beispielhafte Anwendung der Homogenisierungsvorrichtungen ist die Homogenisierung des Magnetfelds eines kernmagnetischen Durchflussmessgeräts. Kernmagnetische Durchflussmessgeräte bestimmen den Durchfluss eines durch ein Messrohr strömenden Mediums aus am Medium durchgeführten kernmagnetischen Resonanz-Messungen. Ein kernmagnetisches Durchflussmessgerät mit Shim-Spulen ist beispielsweise in GB 2 405 935 A beschrieben. Ein Shimträger, welcher einen Trägerinnenraum umgibt und mit Ausnehmungen für Abgleichelemente versehen ist, ist aus WO 2011/122403 A1 bekannt. Der Träger findet in einem geschlossenen System zur MR-Bildgebung Anwendung im Hinblick auf die Homogenisierung eines axialen Magnetfeldes.

Kernmagnetische Resonanz-Messungen erfordern Medien mit Elementen, deren Atomkerne ein magnetisches Moment aufweisen. Das ist bei Atomkernen mit einem Kernspin gegeben. Der Kernspin kann als ein durch einen Vektor beschreibbarer Drehimpuls aufgefasst werden und entsprechend kann auch das magnetische Moment durch einen Vektor beschrieben werden, der parallel zum Vektor des Drehimpulses ausgerichtet ist. Der Vektor des magnetischen Moments eines Atomkerns richtet sich bei Anwesenheit eines Magnetfelds parallel zu dem Vektor des Magnetfelds am Ort des Atomkerns aus. Dabei präzessiert der Vektor des magnetischen Moments des Atomkerns um den Vektor des makroskopischen Magnetfelds am Ort des Atomkerns. Die Frequenz der Präzession wird als Larmorkreisfrequenz ω_{L} bezeichnet und ist proportional zum Betrag der magnetischen Flussdichte B. Die Larmorfrequenz berechnet sich gemäß der Formel ω_{L} = γ*B,* in welcher γ das gyromagnetische Verhältnis ist, das für Wasserstoffkerne maximal ist und γ = 276,5 · 10⁶ rad/(sT) beträgt.

Kernmagnetische Resonanz-Messverfahren regen die ein magnetisches Moment aufweisenden Atomkerne eines Mediums bei Anwesenheit eines Magnetfelds an und messen die Wirkung der Anregung. Bei kemmagnetischen Durchflussmessgeräten wird mit Hilfe der gemessenen Wirkung der Anregung der Durchfluss des Mediums durch das Messrohr bestimmt. Eine Anregung der Atomkerne bewirkt eine gleichphasige Präzession der Atomkerne mit der Larmorkreisfrequenz ω_{L} der zuvor mit statistisch verteilten Phasen zueinander präzessierenden Atomkerne und die Anregung stört den zuvor herrschenden Gleichgewichtszustand der präzessierenden Atomkerne. Die Störung ist, solange die Präzession gleichphasig ist, als makroskopisches Wechselmagnetfeld messbar, wobei die Kreisfrequenz des Wechselmagnetfelds die Larmorkreisfrequenz ist.

Zur Durchführung der kernmagnetischen Resonanz-Messungen weisen kernmagnetische Durchflussmessgeräte eine Magnetfelderzeugungseinrichtung zur Erzeugung des Magnetfelds in dem durch das Messrohr strömenden Medium auf. Dabei beträgt die übliche magnetische Flussdichte im strömenden Medium B ≈ 0,3 T. Eine Schwankung der magnetischen Flussdichte im Medium in der Größenordnung der magnetischen Flussdichte des Erdmagnetfeldes, zum Beispiel um Δ*B* = 30 µT, führt zu einer Schwankung der Larmorkreisfrequenz um Δω_{L} = 276,5 · 10⁶ rad/(sT) · 30 µT ≈ 8,1 · 10³ 1/s der im Medium strömenden präzessierenden Atomkerne. Die Schwankung der Larmorkreisfrequenz selbst führt zur einer Verschlechterung der Messgenauigkeit und bewirkt auch einen Verlust der Gleichphasigkeit der Präzession der Atomkerne, wodurch die Amplitude des makroskopischen Wechselmagnetfeldes abnimmt, was zu einer weiteren Verschlechterung der Messgenauigkeit führt.

Übliche Magnetfelderzeugungseinrichtungen von kernmagnetischen Durchflussmessgeräten werden aus Permanentmagneten aufgebaut, wobei die Permanentmagneten zumeist als Halbach-Arrays angeordnet sind. Jedoch resultiert aus der Homogenität eines derart erzeugten Magnetfeldes zumeist nicht die geforderte Messgenauigkeit von kernmagnetischen Durchflussmessgeräten, weshalb es erforderlich ist, das Magnetfeld durch eine Homogenisierungsvorrichtung zu homogenisieren. Aber auch mit Elektromagneten erzeugte Magnetfelder erfüllen oftmals nicht die von der Anwendung gestellten Anforderungen an die Homogenität des Magnetfelds.

Eine Homogenisierungsvorrichtung der eingangs beschriebenen Art kann insbesondere zur Homogenisierung des von der Magnetfelderzeugungseinrichtung eines kernmagnetischen Durchflussmessgeräts erzeugten Magnetfelds im durch das Messrohr strömenden Medium im Magnetfeld angeordnet sein, und zwar derart, dass das Messrohr im Trägerinnenraum des Trägers der erfindungsgemäßen Homogenisierungsvorrichtung liegt und die Trägerwandung das Messrohr umgibt. Das Magnetfeld der Magnetfelderzeugungseinrichtung dringt dabei durch den ersten Trägerbereich der Trägerwandung in den Trägerinnenraum ein und durch den zweiten Trägerbereich der Trägerwandung aus dem Trägerinnenraum aus. Die am Träger angeordneten Abgleichelemente homogenisieren dabei das Magnetfeld zumindest im Trägerinnenraum und damit auch im Medium.

Der Träger einer Homogenisierungsvorrichtung besteht aus amagnetischen Materialien. Amagnetische Materialien sind dadurch gekennzeichnet, dass sie ein Magnetfeld, wenn überhaupt, nur in einem für die jeweilige Anwendung vernachlässigbar geringen Maß beeinflussen. Auch diamagnetische und paramagnetische Materialien werden als amagnetische Materialien betrachtet. Im Gegensatz dazu bestehen die Abgleichelemente zumindest teilweise aus einem magnetischen Material. Magnetische Materialien sind ferromagnetische, ferrimagnetische und antiferromagnetische Materialien. Ihnen gemein ist, dass sie ein Magnetfeld beeinflussen.

Im Stand der Technik ist eine Homogenisierungsvorrichtung der eingangs beschriebenen Art bekannt, bei der die Anordnung jedes der Abgleichelemente auf dem Träger durch eine Klebung umgesetzt ist. Die Nachteile dieser Homogenisierungsvorrichtung werden bei Betrachtung des mehrere Schritte umfassenden Vorgangs der Homogenisierung eines Magnetfelds offensichtlich.

In einem ersten Schritt wird das Magnetfeld vermessen und entsprechend den Messergebnissen werden für gewöhnlich mehrere der Abgleichelemente am Träger an bestimmtem Positionen angeordnet. In einem zweiten Schritt wird das Magnetfeld mit im Magnetfeld angeordneter Homogenisierungsvorrichtungen im Trägerinnenraum vermessen. In diesem zweiten Schritt ist das Magnetfeld im Trägerinnenraum für gewöhnlich homogener als ohne Homogenisierungsvorrichtung, jedoch genügt die Homogenität des Magnetfelds oftmals noch nicht den Anforderungen der Anwendung. Folglich ist ein dritter Schritt erforderlich, in dem Abgleichelemente entsprechend den Messergebnissen aus dem vorangegangenem Schritt angeordnet, entnommen oder versetzt werden. In einem vierten Schritt wird das Magnetfeld mit im Magnetfeld angeordneter Homogenisierungsvorrichtung im Trägerinnenraum erneut vermessen. In diesem vierten Schritt ist das Magnetfeld im Trägerinnenraum für gewöhnlich homogener als nach dem ersten Schritt. Genügt die Homogenität des Magnetfelds den Anforderungen, ist der Vorgang der Homogenisierung abgeschlossen, andernfalls werden der dritte und vierte Schritt wiederholt, bis die Homogenität den Anforderungen der Anwendung genügt. Demnach ist die Homogenisierung des Magnetfelds ein iterativer Prozess.

Bei der im Stand der Technik bekannten Homogenisierungsvorrichtung ist zur Entnahme und Versetzung jedes einzelnen der Abgleichelemente eine Klebung zu lösen und sind die Reste des Klebers zu entfernen. Wird ein Kleber verwendet, dessen Klebeleistung zur einfachen Entnahme der Abgleichelemente gering ist, ist die Betriebssicherheit der Klebung beeinträchtigt und zusätzliche Maßnahmen zur Fixierung der festgeklebten Abgleichelemente sind zu ergreifen. Wird ein Kleber verwendet, dessen Klebeleistung zur Gewährleistung der Betriebssicherheit der Klebung hoch ist, drohen Beschädigungen am Träger bei Entnahme der Abgleichelemente. Darüber hinaus ist die Reproduzierbarkeit der Anordnung von Abgleichelementen an vorbestimmten Positionen mit störend großen Ungenauigkeiten behaftet.

Aufgabe der vorliegenden Erfindung ist daher die Angabe einer Homogenisierungsvorrichtung zur Homogenisierung eines Magnetfelds, bei der die Handhabung der Homogenisierungsvorrichtung während der Homogenisierung verbessert ist.

Die erfindungsgemäße und in Anspruch 1 definierte Homogenisierungsvorrichtung, bei der die zuvor hergeleitete und aufgezeigte Aufgabe gelöst ist, ist zunächst und im Wesentlichen dadurch ausgezeichnet, dass in der Trägerwandung Ausnehmungen vorgesehen sind und in jeder der Ausnehmungen mindestens eines der Abgleichelemente unmittelbar einsetzbar und entnehmbar ist.

Die erfindungsgemäße Homogenisierungsvorrichtung hat gegenüber aus dem Stand der Technik bekannten Homogenisierungsvorrichtungen zunächst den Vorteil, dass die Abgleichelemente ohne Klebung am Träger angeordnet werden können. Dadurch sind die Anordnung, die Entnahme und auch die Versetzung von Abgleichelementen verbessert. Darüber hinaus ist durch das Einsetzen der Abgleichelemente in die Ausnehmungen auch eine verbesserte Reproduzierbarkeit der Anordnung von Abgleichelementen an vorbestimmten Positionen gegeben.

Für gewöhnlich sind bei für eine Anwendung hinreichender Homogenität des Magnetfelds im Trägerinnenraum nur in einer Teilmenge der Ausnehmungen die Abgleichelemente eingesetzt. Zumeist ist auch in den Ausnehmungen jeweils nur eines der Abgleichelemente eingesetzt. Jedoch können in den Ausnehmungen zur Erreichung hinreichender Homogenität des Magnetfelds auch mindestens zwei der Abgleichelemente zusammen eingesetzt sein. Vorzugsweise weisen die zusammen in eine der Ausnehmungen einsetzbaren Abgleichelemente die gleiche Geometrie wie ein einzelnes der in diese Ausnehmung einsetzbaren Abgleichelemente auf. (Allgemein ist die Geometrie eines Körpers durch seine Form und seine Größe bestimmt.) Darüber hinaus ist auch vorgesehen, die Position und Ausrichtung eines der in einer der Ausnehmungen eingesetzten Abgleichelements in Bezug auf den idealen Magnetfeldvektor in der Ausnehmung durch Füllelemente zwischen dem Abgleichelement und der Ausnehmung einzustellen. Der ideale Magnetfeldvektor ist der eines homogenen Magnetfelds im Trägerinnenraum.

Die in die Ausnehmungen eingesetzten Abgleichelemente sind durch Haftreibung zwischen den Ausnehmungen und den eingesetzten Abgleichelementen zumindest in dem Maß fixiert, dass die durch die Haftreibung bedingte Haftkraft zumindest gleich groß der Gewichtskraft des jeweiligen eingesetzten Abgleichelemente ist und dass die Haftkraft zumindest gleich groß der durch die Abgleichelemente aufeinander ausgeübten Kräfte ist. Die Haftkraft ist durch die Abstimmung der Geometrie der Ausnehmungen auf die Geometrie der in die Ausnehmungen eingesetzten Abgleichelemente einstellbar.

Die Form der Ausnehmungen kann vieler Gestalt sein. Der einfachen Herstellung durch Bohren wegen bieten sich insbesondere kreiszylinderförmige Ausnehmungen an. Aber auch vieleckig geformte Ausnehmungen, zum Beispiel quaderförmige Ausnehmungen sind vorteilhaft, wobei die Herstellung vorzugsweise durch Fräsen erfolgt. Auch die Form der Abgleichelemente kann vieler Gestalt sein. Hier bieten sich kreiszylinderförmige und vieleckig geformte Abgleichelemente an und von den vieleckig geformten insbesondere quaderförmige Abgleichelemente. In kreiszylinderförmige Ausnehmungen sind nicht nur kreiszylinderförmige Abgleichelemente, sondern auch vieleckig geformte Abgleichelemente einsetzbar und umgekehrt sind in vieleckig geformte Ausnehmungen auch kreiszylinderförmige Abgleichelemente einsetzbar. Besonders vorteilhaft ist jedoch das Einsetzen von vieleckig geformten Abgleichelementen in entsprechend vieleckig geformte Ausnehmungen, weil ein Drehen der eingesetzten Abgleichelemente nicht möglich ist.

Bei einer bevorzugten Ausgestaltung der erfindungsgemäßen Homogenisierungsvorrichtung ist im ersten Trägerbereich mindestens eine der Ausnehmungen vorgesehen und/oder ist im zweiten Trägerbereich mindestens eine der Ausnehmungen vorgesehen. In einer ersten alternativen Ausgestaltung ist vorgesehen, dass nur im ersten Trägerbereich mindestens eine der Ausnehmungen vorgesehen ist und in einer zweiten alternativen Ausgestaltung ist vorgesehen, dass nur im zweiten Trägerbereich mindestens eine der Ausnehmungen vorgesehen ist. Ausnehmungen sowohl im ersten Trägerbereich als auch im zweiten Trägerbereich gewähren die größtmögliche Freiheit bei der Anordnung der Abgleichelemente, während bei den beiden alternativen Ausgestaltungen der Herstellungsaufwand durch die geringere Anzahl an Ausnehmungen verringert ist, aber trotzdem eine für viele Anwendungen ausreichende Homogenisierung des Magnetfelds erreichbar ist.

Bei einer anderen bevorzugten Ausgestaltung der erfindungsgemäßen Homogenisierungsvorrichtung ist vorgesehen, dass mindestens eine Teilmenge der Ausnehmungen ein regelmäßiges Muster in der Trägerwandung bildet. Ein regelmäßiges Muster ermöglicht eine gleichmäßige Beeinflussung des Magnetfelds im Trägerinnenraum. Als regelmäßiges Muster bietet sich ein Schachbrettmuster an. Ein Schachbrettmuster ist dadurch gekennzeichnet, dass die Ausnehmungen durch Geraden verbunden sind, die sich in rechten Winkeln schneiden, und dass die Abstände benachbarter Ausnehmungen gleich sind. Das Muster ist demnach eine Matrix und erlaubt auch eine einfache Adressierung der einzelnen Ausnehmungen, zum Beispiel in der Art, wie sie bei Schachbrettern üblich ist.

Bei einer besonders bevorzugten Ausgestaltung der erfindungsgemäßen Homogenisierungsvorrichtung ist vorgesehen, dass mindestens eine der Ausnehmungen als Sackloch mit einem Sacklochboden und einer Sacklochwandung ausgeführt ist. Die als Sackloch ausgeführten Ausnehmungen sind vorteilhaft, weil die Herstellung effizient, insbesondere bei kreisrunden Querschnittskonturen durch Bohren, erfolgen kann und das in eine der als Sackloch ausgeführten Ausnehmungen eingesetzte Abgleichelement durch Formschluss nur noch in eine Richtung bewegbar ist. Vorzugsweise weist mindestens eine Teilmenge der als Sacklöcher ausgeführten Ausnehmungen die gleiche Geometrie auf, wodurch die Effizienz der Herstellung der Ausnehmungen und der Abgleichelemente weiter gesteigert wird.

Vorteilhaft liegt mindestens eine der als Sackloch ausgeführten Ausnehmungen in der Außenseite der Trägerwand. Die Außenseite ist als dem Trägerinnenraum abgewandte Seite der Trägerwandung einfacher zugänglich als eine dem Trägerinnenraum zugewandte Innenseite, weshalb auch die in der Außenseite liegenden Ausnehmungen einfacher zugänglich sind.

Darüber hinaus ist es vorteilhaft, wenn an der Innenseite der Trägerwandung mindestens einer der als Sackloch ausgeführten Ausnehmungen eine in den Sacklochboden der Ausnehmung mündende Auswurfausnehmung zum Auswerfen des in der Ausnehmung eingesetzten Abgleichelements zugeordnet ist. Das Auswerfen eines der in eine der Ausnehmungen eingesetzten Abgleichelemente erfolgt durch Aufbringung einer Kraft durch die Auswurfausnehmung auf das Abgleichelement, wobei die Kraft größer als die Haftkraft des Abgleichelements in der Auswurfausnehmung ist.

Gemäss der Ausgestaltung der erfindungsgemäßen Homogenisierungsvorrichtung ist vorgesehen, dass mindestens eine der Ausnehmungen eine Ausnehmungsachse aufweist, mindestens eines der Abgleichelemente ausschließlich durch Bewegung entlang der Ausnehmungsachse in der Ausnehmung einsetzbar ist und die einzige verbleibende Translationsfreiheit des in der Ausnehmung eingesetzten Abgleichelements entlang der Ausnehmungsachse ist. Das Einsetzen des Abgleichelements ist demnach ein translatorisches Einschieben oder Eindrücken in die Ausnehmung. Vorzugsweise ist zusätzlich mindestens eine Abdeckung vorgesehen und die Abdeckung unterbindet die einzige verbliebene Translationsfreiheit von mindestens einem der in eine der Ausnehmungen eingesetzten Abgleichelemente unterbindet.

Bei einer bevorzugten Ausgestaltung der erfindungsgemäßen Homogenisierungsvorrichtung ist vorgesehen, dass in mindestens einer der Ausnehmungen ein Innengewinde und in mindestens einem der Abgleichelemente ein Außengewinde ausgebildet ist und das Abgleichelement in die Ausnehmung einschraubbar ist. Das Einschrauben des Abgleichelements in die Ausnehmung erlaubt eine wesentlich geringere Haftreibung zwischen dem Abgleichelement und der Ausnehmung zur Fixierung des Abgleichelements in der Ausnehmung.

Die Abgleichelemente bestehen zumindest teilweise aus magnetischem Material. Das magnetische Material von mindestens einem der Abgleichelemente kann sowohl weichmagnetisches Material als auch hartmagnetisches Material enthalten. Demzufolge kann die Gesamtheit der Abgleichelemente einer Homogenisierungsvorrichtung Abgleichelemente enthalten, deren magnetisches Material entweder vollständig weichmagnetisches Material oder vollständig hartmagnetisches Material ist. Auch kann das magnetische Material von jedem der Abgleichelemente ein beliebiges Mischungsverhältnis aus weich-magnetischem Material und hartmagnetischem Material enthalten. Hartmagnetisches Material unterscheidet sich von weichmagnetischem Material durch die höhere Remanenz und die höhere Koerzitivfeldstärke. Folglich ist die Fläche der zwischen der magnetischen Flussdichte und der magnetischen Feldstärke gegebenen Hystereseschleife bei hartmagnetischen Materialien größer als bei weichmagnetischen Materialien. Hartmagnetische Materialien eignen sich besser als weichmagnetische Materialien für Permanentmagnete. Weichmagnetisches Material eignet sich aufgrund des geringen magnetischen Widerstands insbesondere zur Führung eines Magnetfeld.

Bei einer ganz besonders bevorzugten Ausgestaltung der erfindungsgemäßen Homogenisierungsvorrichtung ist vorgesehen, dass die Geometrie von mindestens einem der Abgleichelemente eine Abgleichelementachse aufweist, das Abgleichelement vorzugsweise eine Längsachse aufweist und die Längsachse mit der Abgleichelementachse zusammenfällt. Als Längsachse wird jene Achse eines Körpers bezeichnet, entlang welcher der Körper seine größte räumliche Ausdehnung aufweist. Demnach ist die Wirkung der Abgleichelemente, welche eine Längsachse aufweisen, auf das Magnetfeld abhängig von der Orientierung der Längsachse zu diesem Magnetfeld.

Abgleichelemente, deren Geometrie eine Abgleichelementachse aufweist, können auch derart ausgestaltet sein, das entlang der Abgleichelementachse mindestens eine Schicht aus einem magnetischen Material und mindestens eine Schicht aus einem amagnetischen Material vorhanden ist. Durch die amagnetische Schicht ist der Abstand des magnetischen Materials vom Trägerinnenraum und folglich auch die Wirkung des magnetischen Materials auf das Magnetfeld im Trägerinnenraum einstellbar.

In einer weiteren bevorzugten Ausgestaltung der erfindungsgemäßen Homogenisierungsvorrichtung ist vorgesehen, dass die Abgleichelementachse von mindestens einem der eine Abgleichelementachse aufweisenden und in eine der Ausnehmungen eingesetzten Abgleichelemente durch die Ausnehmung in einem vorgegebenen Winkel zum idealen Magnetfeldvektor ausgerichtet ist. Vorzugsweise ist die Ausrichtung des Abgleichelements parallel zum idealen Magnetfeldvektor. Die Ausrichtung der Abgleichelementachse des Abgleichelements in einem vorgegebenen Winkel zum Magnetfeld ermöglicht nicht nur eine Beeinflussung der Stärke des Magnetfelds im Trägerinnenraum, sondern auch eine Formung des Magnetfelds im Trägerinnenraum. Jedoch ist zumeist eine parallele Ausrichtung der Abgleichelementachsen der Abgleichelemente zum idealen Magnetfeldvektor zur Homogenisierung des Magnetfelds ausreichend.

Bei einer anderen bevorzugten Ausgestaltung der erfindungsgemäßen Homogenisierungsvorrichtung, bei der mindestens eines der Abgleichelemente eine Abgleichelementachse aufweist, weist das magnetische Material eine magnetische Vorzugsachse auf und fällt die Vorzugsachse mit der Abgleichelementachse zusammen. Eine magnetische Vorzugsachse ist dadurch gekennzeichnet, dass die Eigenschaften des magnetischen Materials des Abgleichelements entlang dieser Achse sich von denen entlang einer weiteren Achse senkrecht zu der Vorzugsachse unterscheiden. So kann zum Beispiel vorgesehen sein, dass die Remanenz und/oder der Koerzitivkraft parallel zu der magnetischen Vorzugsachse größer sind als zu einer Achse senkrecht zur Vorzugsachse.

Erfindungsgemäße Homogenisierungsvorrichtungen, bei denen das magnetische Material von mindestens einem der Abgleichelemente hartmagnetisches Material enthält und die Geometrie eine Abgleichelementachse aufweist, sind zwei alternative vorteilhafte Ausgestaltungen möglich. Bei der ersten alternativen Ausgestaltung ist das hartmagnetische Material ein Permanentmagnet und die Magnetachse fällt mit der Abgleichelementachse zusammen. Bei der zweiten alternativen Ausgestaltung ist das in eine der Ausnehmungen eingesetzte Abgleichelement zunächst nicht makroskopisch magnetisiert, sondern die Magnetisierung ist nach dem einsetzen des Permanentmagneten in eine der Ausnehmungen durch ein lokales Magnetisierungsmagnetfeld vorgesehen.

Im Einzelnen gibt es nun verschiedene Möglichkeiten, die erfindungsgemäße Homogenisierungseinrichtung auszugestalten und weiterzubilden. Dazu wird verwiesen sowohl auf die dem Patentanspruch 1 nachgeordneten Patentansprüche als auch auf die Beschreibung bevorzugter Ausführungsbeispiele in Verbindung mit der Zeichnung. In der Zeichnung zeigen
- Fig. 1: ein Ausführungsbeispiel einer erfindungsgemäßen Homogenisierungsvorrichtung,
- Fig. 2: einen vergrößerten Ausschnitt der in Fig. 1 dargestellten Homogenisierungsvorrichtung und
- Fig. 3: ein Abgleichelement einer erfindungsgemäßen Homogenisierungsvorrichtung.

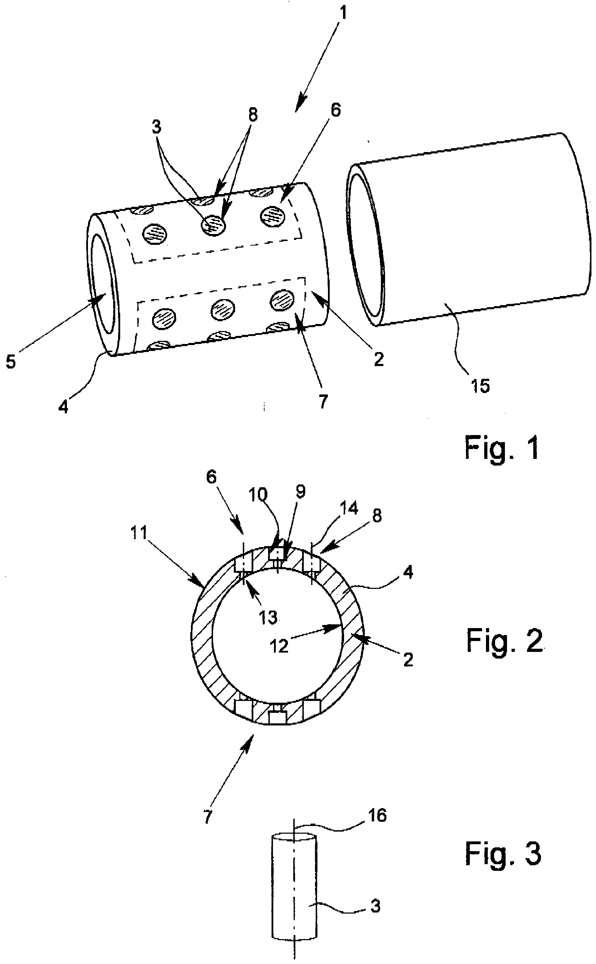

Fig. 1 zeigt die wesentlichen Elemente eines Ausführungsbeispiels einer erfindungsgemäßen Homogenisierungsvorrichtung 1 zur Homogenisierung eines Magnetfelds, die einen amagnetischen Träger 2 und mehrere aus magnetischem Material bestehende Abgleichelemente 3 aufweist. Das amagnetische Material des Trägers 2 ist Aluminium und das magnetische Material, aus dem die Abgleichelemente 3 vollständig bestehen, ist Neodym-Eisen-Bor. Der Träger 2 weist eine Trägerwandung 4 auf, und die Trägerwandung 4 umgibt einen Trägerinnenraum 5. Der Träger 2 ist rohrförmig und einstückig ausgebildet, und sowohl die innere als auch die äußere Querschnittskontur der Trägerwandung 4 sind Kreise mit einem gemeinsamen Mittelpunkt. Auch andere Querschnittskonturen des rohrförmigen Trägers 2 sind möglich, so zum Beispiel ein rohrförmiger Träger 2 mit einer gestuften äußeren Querschnittkontur oder ein rohrförmiger Träger mit rechteckiger innerer und äußerer Querschnittskontur.

Wenn die Homogenisierungsvorrichtung 1 in einem Magnetfeld angeordnet ist, dringt das Magnetfeld durch einen ersten Trägerbereich 6 der Trägerwandung 4 in den Trägerinnenraum 5 ein, durch einen zweiten Trägerbereich 7 der Trägerwandung 4 aus dem Trägerinnenraum 5 aus. Dieses Ausführungsbeispiel einer erfindungsgemäßen Homogenisierungsvorrichtung 1 ist aufgrund der Form des Trägers 2 insbesondere zur Anordnung im Magnetfeld der Magnetfelderzeugungseinrichtung einer der zuvor erwähnten kernmagnetischen Durchflussmessgeräte geeignet, da das Messrohr, durch welches das Medium strömt, dessen Durchfluss zu bestimmen ist, durch den Trägerinnenraum 5 geführt werden kann und der Träger 2 auf einfache Weise am kernmagnetischen Durchflussmessgerät befestigt werden kann.

Sowohl im ersten Trägerbereich 6 als auch im zweiten Trägerbereich 7 der Trägerwandung 4 des Trägers 2 sind jeweils eine Mehrzahl von Ausnehmungen 8 vorgesehen, und die Ausnehmungen 8 sind sowohl im ersten Trägerbereich 6 als auch im zweiten Trägerbereich 7 jeweils in einem Schachbrettmuster in der Trägerwandung 4 angeordnet.

Fig. 2 zeigt einen vergrößerten Ausschnitt der Trägerwandung 4 mit mehreren der Ausnehmungen 8 in Schnittansicht. Die Ausnehmungen 8 des Ausführungsbeispiels einer erfindungsgemäßen Homogenisierungseinrichtung 1 sind, wie die in Fig. 2 dargestellten Ausnehmungen 8, als Sacklöcher ausgeführt, wobei jede der Ausnehmungen 8 einen Sacklochboden 9 und eine Sacklochwandung 10 aufweist. Die Trägerwandung 4 weist eine Außenseite 11 und eine der Außenseite 11 gegenüberliegende und dem Trägerinnenraum 5 zugewandte Innenseite 12 auf, wobei die Ausnehmungen 8 in der Außenseite 11 liegen. In der Trägerwandung 4 sind auch Auswurfausnehmungen 13 vorgesehen, wobei jede der Auswurfausnehmungen 13 in der Innenseite 12 der Trägerwandung 4 liegt und in den Sacklochboden 9 einer der Ausnehmungen 8 mündet.

Die Geometrie der Ausnehmungen 8 ist gleich, die Form weist eine Längsachse auf, und die Querschnittskontur ist ein Kreis. Jede der Ausnehmungen 8 weist auch eine Ausnehmungsachse 14 auf, die parallel zum idealen Magnetfeldvektor ausgerichtet ist und mit der Längsachse zusammenfällt. Auch die Geometrie der Auswurfausnehmungen 13 ist gleich, weist eine Längsachse auf und die Querschnittskontur ist ein Kreis. Jedoch ist die Querschnittsfläche der Auswurfausnehmungen 13 kleiner als die Querschnittsfläche der Ausnehmungen 8, wodurch die Sacklochböden die Form eines Kreisrings aufweisen und der Kreisring den Sitz für das in eine der Ausnehmungen 8 eingesetzte Abgleichelement 3 darstellt. Sowohl die Ausnehmungen 8 als auch die Auswurfausnehmungen 13 sind durch Bohren hergestellt.

Fig. 1 zeigt, dass zu dem Ausführungsbeispiel einer erfindungsgemäßen Homogenisierungsvorrichtung 1 auch noch eine Abdeckung 15 gehört. Die Abdeckung 15 ist ein Rohr, dessen Innendurchmesser an den Außendurchmesser des Trägers 2 angepasst ist und über den Träger 2 schiebbar ist. Die über den Träger 2 geschobene Abdeckung 15 deckt die in der Außenseite 11 liegenden Ausnehmungen 8 ab.

Fig. 3 zeigt eines der Abgleichelemente 3. Die Abgleichelemente 3 sind eine Längsachse aufweisende Vollzylinder aus magnetischem Material mit gleicher Geometrie und die Querschnittskontur ist ein Kreis. Jedes der Abgleichelemente 3 weist auch eine Abgleichelementachse 16 auf, die mit der Längsachse zusammenfällt.

Jedes der Abgleichelemente 3 ist in jede der Ausnehmungen 8 unmittelbar einsetzbar durch eine Bewegung des jeweiligen Abgleichelements 3 entlang der Ausnehmungsachse 14 der jeweiligen Ausnehmung 8 bei Zusammenfallen der Ausnehmungsachse 14 und der Abgleichelementachse 15. Die einzige verbliebene Translationsfreiheit des in die Ausnehmung 8 eingesetzten Abgleichelements 3 ist entlang der Ausnehmungsachse 14. Der Innendurchmesser der Ausnehmung 8 und der Außendurchmesser des Abgleichelements 3 sind derart aufeinander angepasst, dass Haftreibung zwischen der Sacklochwandung 10 und dem Abgleichelement 3 vorhanden ist und die durch die Haftreibung bedingte Haftkraft größer ist als die Kraft, die durch die übrigen Abgleichelemente 3 auf das Abgleichelement 3 ausgeübt wird. Die in die Ausnehmungen 8 eingesetzten Abgleichelemente 3 sind demnach während des Vorgangs der Homogenisierung fixiert. Jedes der in eine der Ausnehmungen 8 eingesetzten Abgleichelemente 3 ist entnehmbar durch Ausübung einer Kraft größer als die Haftkraft durch die Auswurfausnehmung 13 auf das Abgleichelement 3. Die Länge der Abgleichelemente 3 und die Tiefe der Ausnehmungen 8 sind derart aufeinander abgestimmt, dass jedes der in eine der Ausnehmungen 8 eingesetzten Abgleichelemente 3 zum einen in Kontakt mit dem Sacklochboden 9 der Ausnehmung 8 ist und zum anderen zumindest teilweise bündig mit der Außenseite 11 der Trägerwandung 4 abschließt. Wenn die Abdeckung 15 über den Träger 2 geschobene ist, unterbindet die Abdeckung 15 eine Bewegung der Abgleichelemente 3 entlang der jeweils einzigen verbliebenen Translationsfreiheit, auch wenn die auf die Abgleichelemente 3 wirkenden Kräfte die Haftkräfte übersteigen.

### Bezugszeichen:

- 1: Homogenisierungsvorrichtung
- 2: Träger
- 3: Abgleichelement
- 4: Trägerwandung
- 5: Trägerinnenraum
- 6: erster Trägerbereich
- 7: zweiter Trägerbereich
- 8: Ausnehmung
- 9: Sacklochboden
- 10: Sacklochwandung
- 11: Außenseite
- 12: Innenseite
- 13: Auswurfausnehmung
- 14: Ausnehmungsachse
- 15: Abdeckung
- 16: Abgleichelementachse

## Patentansprüche

1. Homogenisierungsvorrichtung zur Homogenisierung eines Magnetfelds mit einem amagnetischen Träger (2) und zumindest teilweise aus einem magnetischen Material bestehenden und am Träger angeordneten Abgleichelementen (3),
wobei der Träger (2) eine Trägerwandung (4) aufweist und die Trägerwandung (4) einen Trägerinnenraum (5) umgibt,
wobei in der Trägerwandung (4) Ausnehmungen (8) vorgesehen sind und in jeder der Ausnehmungen (8) mindestens eines der Abgleichelemente (3) unmittelbar einsetzbar und entnehmbar ist,
wobei mindestens eine der Ausnehmungen (8) eine Ausnehmungsachse (14) aufweist und wobei die Homogenisierungsvorrichtung dazu eingerichtet ist, ein Magnetfeld zu homogenisieren, das durch einen ersten Trägerbereich (6) der Trägerwandung (4) in den Trägerinnenraum (5) eindringt und durch einen zweiten Trägerbereich (7) der Trägerwandung (4) aus dem Trägerinnenraum (5) ausdringt, wobei jedes der am Träger (2) angeordneten Abgleichelemente (3) zur Homogenisierung des Magnetfelds zumindest im Trägerinnenraum (5) beiträgt, und
wobei mindestens eines der Abgleichelemente (3) ausschließlich durch Bewegung entlang der Ausnehmungsachse (14) in der Ausnehmung (8) einsetzbar ist und die einzige verbleibende Translationsfreiheit des in der Ausnehmung (8) eingesetzten Abgleichelements (3) entlang der Ausnehmungsachse (14) ist.

2. Homogenisierungsvorrichtung nach Anspruch 1, wobei im ersten Trägerbereich (6) mindestens eine der Ausnehmungen (8) vorgesehen ist oder/und im zweiten Trägerbereich (7) mindestens eine der Ausnehmungen (8) vorgesehen ist.

3. Homogenisierungsvorrichtung nach Anspruch 1 oder 2, wobei mindestens eine Teilmenge der Ausnehmungen (8) ein regelmäßiges Muster in der Trägerwandung (4) bildet.

4. Homogenisierungsvorrichtung nach einem der Ansprüche 1 bis 3, wobei mindestens eine der Ausnehmungen (8) als Sackloch mit einem Sacklochboden (9) und einer Sacklochwandung (10) ausgeführt ist und vorzugsweise mindestens eine Teilmenge der als Sacklöcher ausgeführten Ausnehmungen (8) die gleiche Geometrie aufweist.

5. Homogenisierungsvorrichtung nach Anspruch 4, wobei die Trägerwandung (4) eine Außenseite (11) aufweist, wobei mindestens eine der als Sackloch ausgeführten Ausnehmungen (8) in der Außenseite (11) liegt.

6. Homogenisierungsvorrichtung nach Anspruch 4 oder 5, wobei die Trägerwandung (4) eine Innenseite (12) aufweist und an der Innenseite (12) der Trägerwandung (4) an mindestens einer der als Sackloch ausgeführten Ausnehmungen (8) eine in den Sacklochboden (10) der Ausnehmung (8) mündende Auswurfausnehmung (13) zum Auswerfen des in der Ausnehmung (8) eingesetzten Abgleichelements (3) vorgesehen ist.

7. Homogenisierungsvorrichtung nach einem der Ansprüche 1 bis 6, wobei mindestens eine Abdeckung (15) vorgesehen ist und die Abdeckung (15) die einzige verbliebene Translationsfreiheit von mindestens einem der in eine der Ausnehmungen (8) eingesetzten Abgleichelemente (3) unterbindet.

8. Homogenisierungsvorrichtung nach einem der Ansprüche 1 bis 7, wobei in mindestens einer der Ausnehmungen (8) ein Innengewinde und in mindestens einem der Abgleichelemente (3) ein Außengewinde ausgebildet ist und das Abgleichelement (3) in die Ausnehmung (8) einschraubbar ist.

9. Homogenisierungsvorrichtung nach einem der Ansprüche 1 bis 8, wobei das magnetische Material von mindestens einem der Abgleichelemente (3) weichmagnetisches Material enthält und/oder das magnetische Material von mindestens einem der Abgleichelemente (3) hartmagnetisches Material enthält.

10. Homogenisierungsvorrichtung nach einem der Ansprüche 1 bis 9, wobei die Form von mindestens einem der Abgleichelemente (3) eine Abgleichelementachse (16) aufweist, das Abgleichelement (3) vorzugsweise eine Längsachse aufweist und die Längsachse mit der Abgleichelementachse (16) zusammenfällt.

11. Homogenisierungsvorrichtung nach Anspruch 10, wobei mindestens eines der eine Abgleichelementachse (16) aufweisenden Abgleichelemente (3) entlang der Abgleichelementachse (16) mindestens eine Schicht aus einem magnetischen Material und mindestens eine Schicht aus einem amagnetischen Material aufweist.

12. Homogenisierungsvorrichtung nach Anspruch 10 oder 11, wobei die Abgleichelementachse (16) von mindestens einem der eine Abgleichelementachse (16) aufweisenden und in eine der Ausnehmungen (8) eingesetzten Abgleichelemente durch die Ausnehmung (8) in einem vorgegebenen Winkel zum idealen Magnetfeldvektor ausgerichtet ist, vorzugsweise die Abgleichelementachse (16) parallel zum idealen Magnetfeldvektor ausgerichtet ist.

13. Homogenisierungsvorrichtung nach einem der Ansprüche 10 bis 12, wobei das magnetische Material von mindestens einem der eine Abgleichelementachse (16) aufweisenden Abgleichelemente (3) eine magnetische Vorzugsachse aufweist und die Vorzugsachse mit der Abgleichelementachse (16) zusammenfällt.

14. Homogenisierungsvorrichtung nach Anspruch 9 und einem der Ansprüche 10 bis 13, wobei das hartmagnetische Material von mindestens einem der hartmagnetisches Material enthaltenden Abgleichelemente (3) ein Permanentmagnet ist und die Magnetachse mit der Abgleichelementachse (16) zusammenfällt.

15. Homogenisierungsvorrichtung nach Anspruch 9 und einem der Ansprüche 10 bis 13, wobei die Magnetisierung des hartmagnetischen Materials von mindestens einem der hartmagnetisches Material enthaltenden Abgleichelemente (3) nach dem Einsetzen des Abgleichelements (3) in eine der Ausnehmungen (8) durch ein lokales Magnetisierungsmagnetfeld vorgesehen ist.

## Claims

1. Homogenization device for homogenization of a magnetic field, having a non-magnetic carrier (2) and compensation elements (3) consisting at least partially of a magnetic material and being arranged on the carrier,
wherein the carrier (2) has a carrier wall (4) and the carrier wall (4) surrounds a carrier interior (5),
wherein recesses (8) are provided in the carrier wall (4) and at least one of the compensation elements (3) can be inserted and removed directly in each of the recesses,
wherein at least one of the recesses (8) has a recess axis (14), and
wherein the homogenization device is designed to homogenize a magnetic field that penetrates the carrier wall (4) into the carrier interior (5) through a first carrier region (6) and penetrates the carrier wall (4) out of the carrier interior (5) through a second carrier region (7), wherein each of the compensation elements (3) arranged on the carrier (2) contributes to the homogenization of the magnetic field at least in the carrier interior (5), and
wherein at least one of the compensation elements (3) is insertable solely by movement along the recess axis (14) and the sole remaining translational freedom of the compensation element (3) inserted in the recess (8) is along the recess axis (14).

2. Homogenization device according to claim 1, wherein at least one of the recesses (8) is provided in the first carrier region (6) and/or at least one of the recesses (8) is provided in the second carrier region (7).

3. Homogenization device according to claim 1 or 2, wherein at least one subset of the recesses (8) forms a regular pattern in the carrier wall (4).

4. Homogenization device according to any one of claims 1 to 3, wherein at least one of the recesses (8) is implemented as a blind hole with a blind hole bottom (9) and a blind hole wall (10) and, preferably, at least one subset of the recesses (8) implemented as blind holes has the same geometry.

5. Homogenization device according to claim 4, wherein the carrier wall (4) has an outer side (11), wherein at least one of the recesses (8) in the form of a blind hole is located in the outer side (11).

6. Homogenization device according to claim 4 or 5, wherein the carrier wall (4) has an inner side (12) and an ejection opening (13) connecting to the blind hole bottom (9) of the recess is provided on the inner side (12) of the carrier wall (4) on at least one of the recesses (8) designed as blind hole for ejecting the compensation element (3) inserted in the recess (8).

7. Homogenization device according to any one of claims 1 to 6, wherein at least one cover (15) is provided and the cover (15) prevents the sole remaining translational freedom of at least one of the inserted compensation elements (3) inserted in one of the recesses (8).

8. Homogenization device according to any one of claims 1 to 7, wherein at least one of the recesses (8) has an internal thread and at least one of the compensation elements (3) has an external thread and the compensation element(3) can be screwed into the recess (8).

9. Homogenization device according to any one of claims 1 to 8, wherein the magnetic material of at least one of the compensation elements (3) comprises a soft magnetic material and/or the magnetic material of at least one of the compensation elements (3) comprises a hard magnetic material.

10. Homogenization device according to any one of claims 1 to 9, wherein the shape of at least one of the compensation elements (3) has a compensation element axis (16), the compensation element (3) preferably has a longitudinal axis and the longitudinal axis coincides with compensation element axis (16).

11. Homogenization device according to claim 10, wherein at least one of the compensation elements (3) having a compensation element axis (16) has at least one layer of a magnetic material and at least one layer of a non-magnetic material.

12. Homogenization device according to claim 10 or 11, wherein the compensation element axis (16) of at least one of the compensation elements having a compensation element axis (16) and being inserted in one of the recesses (8) is aligned by the recess at a given angle relative to an ideal magnetic field vector, preferably the compensation element axis (16) is aligned parallel to the ideal magnetic field vector.

13. Homogenization device according to any one of claims 10 to 12, wherein the magnetic material of at least one of the compensation elements (3) having a compensation element axis (16) has a preferred magnetic axis and the preferred magnetic axis coincides with the compensation element axis (16).

14. Homogenization device according to claim 9 and any one of claims 10 to 13, wherein the hard magnetic material of at least one of the compensation elements (3) containing the hard magnetic material is a permanent magnet and the magnet axis coincides with the compensation element axis (16).

15. Homogenization device according to claim 9 and any one of claims 10 to 13, wherein the magnetization of the hard magnetic material of at least one of the compensation elements (3) containing the hard magnetic material is provided by a local magnetization magnetic field after insertion of the compensation element (3) in one of the recesses (8).

## Revendications

1. Dispositif d'homogénéisation destiné à homogénéiser un champ magnétique, comprenant un élément porteur (2) amagnétique et des éléments d'égalisation (3) constitués au moins partiellement d'un matériau magnétique et disposés sur l'élément porteur,
l'élément porteur (2) possédant une paroi d'élément porteur (4) et la paroi d'élément porteur (4) entourant un espace intérieur d'élément porteur (5),
des cavités (8) se trouvant dans la paroi d'élément porteur (4) et au moins l'un des éléments d'égalisation (3) pouvant être inséré directement dans chacune des cavités (8) et pouvant en être retiré directement,
au moins l'une des cavités (8) possédant un axe de cavité (14) et
le dispositif d'homogénéisation étant conçu pour homogénéiser un champ magnétique qui pénètre dans l'espace intérieur d'élément porteur (5) à travers une première zone d'élément porteur (6) de la paroi d'élément porteur (4) et s'échappe hors de l'espace intérieur d'élément porteur (5) à travers une deuxième zone d'élément porteur (7) de la paroi d'élément porteur (4), chacun des éléments d'égalisation (3) disposés sur l'élément porteur (2) contribuant à l'homogénéisation du champ magnétique au moins dans l'espace intérieur d'élément porteur (5) et
au moins l'un des éléments d'égalisation (3) pouvant être inséré dans la cavité (8) exclusivement par un mouvement le long de l'axe de cavité (14) et l'unique liberté de translation restante de l'élément d'égalisation (3) inséré dans la cavité (8) étant le long de l'axe de cavité (14) .

2. Dispositif d'homogénéisation selon la revendication 1, au moins l'une des cavités (8) se trouvant dans la première zone d'élément porteur (6) et/ou au moins l'une des cavités (8) se trouvant dans la deuxième zone d'élément porteur (7).

3. Dispositif d'homogénéisation selon la revendication 1 ou 2, au moins un sous-ensemble des cavités (8) formant un modèle régulier dans la paroi d'élément porteur (4).

4. Dispositif d'homogénéisation selon l'une des revendications 1 à 3, au moins l'une des cavités (8) étant réalisée sous la forme d'un trou borgne ayant un fond de trou borgne (9) et une paroi de trou borgne (10) et de préférence au moins un sous-ensemble des cavités (8) réalisées sous la forme de trous borgnes possédant la même géométrie.

5. Dispositif d'homogénéisation selon la revendication 4, la paroi d'élément porteur (4) possédant un côté extérieur (11), au moins l'une des cavités (8) réalisées sous la forme d'un trou borgne se trouvant dans le côté extérieur (11).

6. Dispositif d'homogénéisation selon la revendication 4 ou 5, la paroi d'élément porteur (4) possédant un côté intérieur (12) et une cavité d'éjection (13), destinée à éjecter l'élément d'égalisation (3) inséré dans la cavité (8) et qui débouche dans le fond de trou borgne (9) de la cavité (8), se trouve sur le côté intérieur (12) de la paroi d'élément porteur (4) au niveau d'au moins l'une des cavités (8) réalisées sous la forme d'un trou borgne.

7. Dispositif d'homogénéisation selon l'une des revendications 1 à 6, au moins un élément de recouvrement (15) étant présent et l'élément de recouvrement (15) inhibant l'unique liberté de translation restante d'au moins l'un des éléments d'égalisation (3) insérés dans l'une des cavités (8).

8. Dispositif d'homogénéisation selon l'une des revendications 1 à 7, un filetage femelle étant formé dans au moins l'une des cavités (8) et un filetage mâle dans au moins l'un des éléments d'égalisation (3) et l'élément d'égalisation (3) pouvant être vissé dans la cavité (8).

9. Dispositif d'homogénéisation selon l'une des revendications 1 à 8, le matériau magnétique d'au moins l'un des éléments d'égalisation (3) contenant du matériau magnétique doux et/ou le matériau magnétique d'au moins l'un des éléments d'égalisation (3) contenant du matériau magnétique dur.

10. Dispositif d'homogénéisation selon l'une des revendications 1 à 9, la forme d'au moins l'un des éléments d'égalisation (3) possédant un axe d'élément d'égalisation (16), l'élément d'égalisation (3) possédant de préférence un axe longitudinal et l'axe longitudinal coïncidant avec l'axe d'élément d'égalisation (16).

11. Dispositif d'homogénéisation selon la revendication 10, au moins l'un des éléments d'égalisation (3) qui possède un axe d'élément d'égalisation (16) possédant, le long de l'axe d'élément d'égalisation (16), au moins une couche en un matériau magnétique et au moins une couche en un matériau amagnétique.

12. Dispositif d'homogénéisation selon la revendication 10 ou 11, l'axe d'élément d'égalisation (16) d'au moins l'un des éléments d'égalisation qui possède un axe d'élément d'égalisation (16) et qui est inséré dans l'une des cavités (8) étant orienté par la cavité (8) selon un angle prédéfini par rapport au vecteur de champ magnétique idéal, l'axe d'élément d'égalisation (16) étant de préférence orienté parallèlement au vecteur de champ magnétique idéal.

13. Dispositif d'homogénéisation selon l'une des revendications 10 à 12, le matériau magnétique d'au moins l'un des éléments d'égalisation (3) qui possède un axe d'élément d'égalisation (16) possédant un axe préférentiel magnétique et l'axe préférentiel coïncidant avec l'axe d'élément d'égalisation (16).

14. Dispositif d'homogénéisation selon la revendication 9 et selon l'une des revendications 10 à 13, le matériau magnétique dur d'au moins l'un des éléments d'égalisation (3) contenant le matériau magnétique dur étant un aimant permanent et l'axe d'aimant coïncidant avec l'axe d'élément d'égalisation (16).

15. Dispositif d'homogénéisation selon la revendication 9 et selon l'une des revendications 10 à 13, la magnétisation du matériau magnétique dur d'au moins l'un des éléments d'égalisation (3) contenant le matériau magnétique dur étant prévue après l'insertion de l'élément d'égalisation (3) dans l'une des cavités (8) par un champ magnétique de magnétisation local.
